# EUROPEAN PATENT SPECIFICATION

(11) **EP 0 607 962 B1**
(45) Date of publication and mention of the grant of the patent: **17.07.1996**
(21) Application number: 94100788.2
(22) Date of filing: 20.01.1994
(51) Int. Cl.: G03F 7/033

(54) **Photosensitive resin composition**
Fotoempfindliche Harzzusammensetzung
Composition à base de résine photosensible

(30) Priority: 20.01.1993 JP 23539/93
(43) Date of publication of application: 27.07.1994
(73) Proprietor: JAPAN SYNTHETIC RUBBER CO., LTD., Tokyo-to (JP); Nippon Paint Co., Ltd., Osaka-shi Osaka-fu (JP)
(72) Inventor: Kanda, Kazunori, Yao-shi, Osaka-fu (JP); Kusuda, Hidefumi, Takatsuki-shi, Osaka-fu (JP); Hayashi, Tadashi, Hirakata-shi, Osaka-fu (JP); Sato, Hozumi, Yokkaichi-shi, Mie-ken (JP); Koshimura, Katsuo, Yokkaichi-shi, Mie-ken (JP)
(74) Representative: Hansen, Bernd, Dr. Dipl.-Chem.

(56) References cited:
- EP-A- 0 251 228
- EP-A- 0 277 418
- EP-A- 0 489 553
- US-A- 5 073 477

## Description

### FIELD OF THE INVENTION

The present invention relates to a novel photosensitive resin composition having water-developability.

### BACKGROUND OF THE INVENTION

Various photosensitive resin compositions have heretofore been broadly used in the field of photoresists, printing ink, imprinting material or the like.

Photosensitive resin compositions illustratively include a composition containing cyclized rubber and bisazide compound; a composition containing thermoplastic elastomer, acrylic monomer and photopolymerization initiator; and a composition mainly containing photosensitive resin such as polyester acrylate, epoxyacrylate, polycinnamic acid vinyl ester, chloromethylated polystyrene and resin containing aromatic azido group; or the like, but all of these photosensitive resin compositions are water insoluble and require to use organic solvent at the time of developing. However, there has been raised problems of environmental influence of organic solvents, safety and health during operation.

Alkali-developable photosensitive resin compositions consisting of Novalak resin or poly (vinyl phenol) and quinonediazide compound are known as a means for solving these problems, but it is further desired to develop photosensitive resin compositions which can be easily developed with water and can be safely and simply treated.

As the water-developable photosensitive resin compositions, there have already been proposed those compositions containing a water-soluble resins as a base, for example, a composition composed of a water-soluble resin such as polyvinyl alcohol, gelatin, casein or the like and a dichromate, diazonium salt or bisazide compound, or a composition composed of a water-soluble resin, a water-soluble acrylic monomer and a photopolymerization initiator, or the like. However, since such known water-developable photosensitive resin compositions contain a base resin having too high affinity to water, the compositions swell in developing, which causes lowering strength and reducing dimensions. As a result there would cause various problems such as lowering dimensional accuracy of resist, reducing printing resistance and lowering printing quality.

In order to solve these problems of the water-developable photosensitive resin composition, the present applicants propose a water-developable resin composition which is prepared by mixing (ii) a photopolymerizable unsaturated monomer and (iii) a photopolymerization initiator with (i) a partially cross-linked copolymer made from an aliphatic conjugated diene type monomer, an α,β-ethylenic unsaturated carboxylic acid and a polyfunctional vinyl compound, said copolymer being soluble in aqueous alkali solution (for example, Japanese Patent Kokai 60-179411, Japanese Patent Kokai 60-219208, Japanese Patent Kokai 61-181811 specifications). Further, there is disclosed a water-developable photosensitive resin composition containing (i) a partially cross-linked copolymer made by emulsion polymerization between an aliphatic conjugated diene, an α,β-ethylenic unsaturated carboxylic acid and a compound having at least two groups capable of additional polymerisation (ii) an aliphatic conjugated diene polymer, (iii) a photopolymerizable unsaturated monomer, (iv) a basic nitrogen atom conatining compound and (v) a photopolymerization initiator (for example, Japanese Patent Kokai 1-300246 specification). However, further improvement of the strength of a resin plate after photosetting the water-developing photosensitive resin composition is desired. Furthermore, it is known in for example, Japanese Patent Kokai 62-84113 specification that various physical properties and water-proof of the photosensitive resin composition can be improved by using a curable composition which contains reactive very fine granules obtained by chemically denaturing a cross-linked copolymer coming from emulsion polymerization. However, it is difficult to afford necessary water-developability and elasticity to the composition.

### SUMMARY OF THE INVENTION

Thus, an object of the present invention is to provide a novel water developable photosensitive resin composition with excellent balance of features, excellent strength of a resin plate after photosetting and good elongation at rupture and resilience.

Accordingly, the present invention relates to a photosensitive resin composition comprising;
(1) a photopolymerizable copolymer made by introducing a photopolymerizable group through reacting a photopolymerizable group-containing compound with a copolymer of monomer mixture containing (i) 10 - 95 mol% of an aliphatic conjugated diene, (ii) 0.1 - 30 mol% of a carboxylic group-containing ethylenic unsaturated monomer, (iii) 0.1 - 20 mol% of a compound having at least two polymerizable unsaturated groups and (iv) 0 - 30 mol% of another copolymerizable monomer ((i)+(ii)+(iii)+(iv) = 100 mol%) via said functional group, wherein the photopolymerizable group-containing compound is included in an amount of 0.1 to 20 parts by weight, based on 100 parts by weight of the carboxyl group-containing copolymer,
(2) a photopolymerizable unsaturated monomer,
(3) an amino group-containing compound and
(4) a photopolymerization initiator.

The present invention will be explained in detail below, and the object, constitution and effect of the present invention would be cleared thereby.

### First Ingredient:

At first, the first ingredient constituting the photosensitive resin composition of the present invention is prepared by copolymerizing a monomer mixture containing (i) an aliphatic conjugated diene, (ii) an ethylenic unsaturated monomer containing a carboxyl group and (iii) a compound having at least two polymerizable unsaturated groups (essential components), if necessary, with (iv) another copolymerizable monomer to give a carboxyl group-containing copolymer, and then introducing a photopolymerizable group into the carboxyl group-containing copolymer. The final copolymer is hereinafter referred to as "photopolymerizable copolymer (1)".

In the monomer mixture in preparing the carboxyl group-containing copolymer, an appropriate content of the aliphatic conjugated diene (i) is 10 - 95 mol%, preferable 30 - 90 mol%, an appropriate content of the ethylenic unsaturated monomer (ii) containing carboxyl group is 0.1 - 30 mol%, 0.1 - 20 mol%, and an appropriate content of the compound (iii) having at least two polymerizable unsaturated groups is 0.1 - 20 mol%, preferably 0.5 - 10 mol%. When the content of the aliphatic conjugated diene (i) is less than 10 mol%, the strength of the photosensitive resin composition after photosetting lowers, and when it exceeds 95 mol% insufficient water-developability of the photosensitive resin composition is given . When the content of the carboxyl group-containing ethylenic unsaturated monomer (ii) is less than 0.1 mol%, the water developability of the photosensitive resin composition becomes insufficient, and when it exceeds 30 mol%, the photosensitive resin composition after cured becomes hard and fragile with lowering water-proof. If the content of the a compound (iii) having at least two unsaturated polymerizable unsaturated groups is less than 0.1 mol%, the photosensitive resin composition has insufficient water-developability, and if it exceeds 20 mol%, the compatibility of (1) photopolymerizable copolymerizable copolymer and (2) photopolymerizable unsaturated monomer would lowers to result in insufficient workability of the photosensitive resin composition. The strength of the cured resin composition is poor. Further, an appropriate content of the other copolymerizable monomer (iv) in the monomer mixture is not more than 30 mol%.

Examples of the aliphatic conjugated diene (i) are butadiene, isoprene, 1,3-pentadiene, 1,3-hexadiene, 2,3-dimethylbutadiene, 4,5-diethyl-1,3-octadiene, 3-butyl-1,3-octadiene, chloroprene, and 2,3-dichlorobutadiene.

These aliphatic conjugated dienes can be used solely or in a mixture of two or more members.

Examples of the carboxyl group-containing ethylenic unsaturated monomers are α,β-ethylenic unsaturated monocarboxylic acids, such as (meth)acrylic acid, crotonic acid, cinnamic acid or the like; α,β-ethylenic unsaturated polycarboxylic acids such as itaconic acid, itaconic anhydride, maleic acid, maleic anhydride, fumaric acid, citraconic acid, mesaconic acid, itaconic acid or the like; free carboxyl group-containing esters such as monomethyl ester, monoethyl ester, monopropyl ester or the like of the above mentioned α,β-ethylenic unsaturated polycarboxylic acids; free carboxyl group-containing nitrile compounds such as mononitrile derivatives of the α,β-ethylenic unsaturated polycarboxylic acids; free carboxyl group containing-amid compounds such as monoamide derivatives of the α,β-ethylenic unsaturated polycarboxylic acid; free carboxylic group-containing hydroxyalkyl esters such as mono(2-hydroxyethyl ester), mono(2-hydroxypropyl ester) or the like of the α,β-ethylenic unsaturated polycarboxylic acids; hydroxyl group-containing compounds such as N-hydroxyalkyl derivatives such as the free carboxyl group containing-amide compounds; free carboxyl group containing unsaturated alchohol esters of polyhydric carboxylic acid (e.g. monovinyl succinate, monoalkyl succinate, monovinyl adipate, monoallyl adipate, monovinyl phthalate, monoallyl phthalate or the like). Preferred are acrylic acid, methacrylic acid, crotonic acid, cinnamic acid, itaconic acid, maleic acid, and mono-ester of 2-hydroxyethyl (meth)acrylate and phthalic acid or succinic acid.

These carboxyl group-containing ethylenic unsaturated monomers (ii) can be used solely or in a mixture of two or more members.

As the compounds (iii) having at least two polymerizable unsaturated groups are exemplified alkylene glycol di(meth)acrylate such as ethylene glycol di(meth)acrylate, propylene glycol di(meth)acrylate, 1,4-butandiol di(meth)acrylate, 1,5-pentandiol di(meth)acrylate, 1,6-hexanediol di(meth)acrylate and the like; di(meth)acrylates of polyalkylene glycols (unit number of alkylene glycol: e.g. 2 - 23) such as polyethylene glycol, polypropylene glycol or the like; di(meth)acrylates of polymers having hydroxy groups at both terminals such as both terminal hydroxy-polybutadiene, both terminal hydroxy-polyisoprene, both terminal hydroxy-butadiene-acrylonitrile copolymer, both terminal hydroxypolycaprolactone or the like; oligo(meth)acrylates such as di(meth)acrylate, tri(meth)acrylate, tetra(meth)acrylate or the like of a polyhydric alcohol of trivalence or more valence such as glycerin, 1,2,4-butanetriol, trimethylolalkane (carbon number of the alkane; e.g. 1 ^{∼} 3), tetramethylol alkane (carbon number of the alkane; e.g. 1 - 3), pentaerythritol or the like; oligo(meth)acrylates of polyalkylene glycol adduct of a polyhydric alcohol in trivalene or more valence; oligo(meth)acrylates of cyclic polyhydric alcohol such as 1,4-cyclohexanediol, 1,4-benzenediol or the like; oligo(meth)acrylate prepolymers such as polyester (meth)acrylate, epoxy (meth)acrylate, urethane (meth)acrylate, alkyd resin (meth)acrylate, silicone resin (meth)acrylate, spirane resin (meth)acrylate or the like; bis(meth)acrylamides such as N,N'-methylenebis(meth)acrylamide, N,N'-ethylenebis(meth)-acrylamide, N,N'-hexamethylenebis(meth)acrylamide or the like; polyvinyl aromatic compounds such as divinylbenzene, diisopropenylbenzene, trivinylbenzene or the like; polyhydric carboxylic acid unsaturated alcohol esters such as divinyl phthalate, diallyl phthalate or the like; and multifunctional unsaturated esters such as divinyl ether, diallyl ether or the like. Preferred are ethylene glycol di(meth)acrylate, propylene glycol di(meth)acrylate, divinylbenzene, hexanediol di(meth)acrylate, pentaerythritol tri(meth)acrylate, pentaerythritol tetra(meth)acrylate, and trimethylolpropane tri(meth)acrylate.

These compounds (iii) having at least two polymerizable unsaturated groups can be used solely or in a mixture of two or more members.

Further, the other copolymerizable monomer (iv) may not be limited in particular, but illustratively includes styrene, α-methylstyrene, o-methylstyrene, m-methylstyrene, p-methylstyrene, p-t-butylstyrene, o-chlorostyrene, m-chlorostyrene, p-chlorostyrene, 1,1-diphenylethylene, N-N-dimethyl-p-aminostyrene, N-N-diethyl-p-aminostyrene, vinylpyridine, vinylpiperidine, vinylpyrrolidone, (meth)acrylonitrile, α-chloroacrylonitrile, α-chloromethylacrylonitrile, α-methoxyacrylonitrile_{,} α-ethoxyacrylonitrile, crotononitrile, cinnamonitrile, itaconodinitrile, maleic dinitrile, fumaric dinitrile, (meth)acrylamide, crotonamide, cinnamamide, methyl (meth)acrylate, ethyl (meth)acrylate, n-propyl (meth)acrylate, isopropyl (meth)acrylate, n-butyl (meth)acrylate, isobutyl (meth)acrylate, sec-butyl (meth)acrylate, t-butyl (meth)acrylate, n-amyl (meth)acrylate, n-octyl (meth)acrylate, 2-ethylhexyl (meth)acrylate, lauryl (meth)acrylate, stearyl (meth)acrylate, methyl crotonate, ethyl crotonate, propyl crotonate, butyl crotonate, methyl cinnamate, ethyl cinnamate, propyl cinnamate, butyl cinnamate, dimethyl itaconate, diethyl itaconate, dimethyl maleate, diethyl maleate, dimethyl fumarate, diethyl fumarate, vinyl chloride, vinylidene chloride, vinyl acetate, allyl acetate, etc.; hydroxy group-containing monomers such as N-hydroxymethyl (meth)acrylamide, N-(2-hydroxyethyl) (meth)acrylamide, N,N-bis(2-hydroxyethyl) (meth)acrylamide, 2-hydroxyethyl (meth)acrylate, 2-hydroxypropyl (meth)acrylate, 2-hydroxyethyl crotonate, 2-hydroxypropyl crotonate, 2-hydroxyethyl cinnamate, 2-hydroxy-propyl cinnamate, N-hydroxymethylamide crotonate, N-(2-hydroxyethyl)amide crotonate, N-hydroxymethylamide cinnamate, N-(2-hydroxyethyl)amide cinnamate, allyl alcohol, o-hydroxystyrene, m-hydroxystyrene, p-hydroxystyrene, ethylene glycol mono(meth)acrylate, propylene glycol mono(meth)acrylate; amino group-containing monomers such as vinylamine, allylamine, o-aminostyrene, m-aminostyrene, p-aminostyrene, 2-aminoethyl (meth)acrylate, 2-aminopropyl (meth)acrylate or the like; epoxy group-containing monomers such as glycidyl (meth)acrylate, allyl glycidyl ether or the like; and carbonyl group-containing monomers such as acrolein, vinyl methyl ketone or the like. Preferred are styrene, acrylonitrile, methyl (meth)acrylate, ethyl (meth)acrylate, 2-ethylhexyl (meth)acrylate, methoxyethyl acrylate, methoxy diethylene glycol monoacrylate, methoxy dipropylene glycol monoacrylate, and lauryl (meth)acrylate.

These other copolymerizable monomers (iv) can be used solely or in a mixture of two or more members.

In the present invention, copolymerization of the monomer mixture consisting of the monomer components (i) - (iii), if necessary, together with the other copolymerizable monomer (iv) can be effected in an appropriate method such as emulsion polymerization, suspension polymerization, polymerization in organic medium, bulk polymerization or the like. Preferred copolymerization includes emulsion polymerization and suspension polymerization using water as polymerization medium.

In the present invention, the photopolymerizable copolymer (1) may be preferably granular, and therefore the copolymer containing carboxyl group also may be preferably granular. The granular copolymer containing carboxyl group can be prepared directly, for example, by emulsion polymerization, suspension polymerization, precipitation polymerization or the like using a radical polymerization initiator. It can also be prepared by granulating a previously produced bulky copolymer or by getting a copolymer in granular form from a copolymer solution. It is preferably prepared by emulsion polymerization or suspension polymerization, but the emulsion polymerization is preferred in view of homogeneity of granular size, granular diameter or the like. In this case, an appropriate average granular diameter of the copolymer is 20 - 1000 nm.

As the radical polymerization initiator, there are exemplified organic peroxides such as benzoyl peroxide, lauroyl peroxide, cumene hydroperoxide, paramenthane hydroperoxide, di-t-butyl peroxide or the like; azo compounds such as azobisisobutyronitrile, azobisisovaleronitrile, azobisisocapronitrile or the like; inorganic peroxides such as potassium persulfate, ammonium persulfate, hydrogen peroxide or the like; redox catalysts consisting of the organic or inorganic peroxides and reducing agents such as organic amine, ferrous sulfate, sodium sulfite, sodium thiosulfate, sodium formaldehyde sulfoxylate, L-ascorbic acid, sulfinic acid or the like.

As emulsifiers used in the emulsion polymerization there are exemplified anionic surfactants, nonionic surfactants, cationic surfactants, amphoteric surfactants and the like. In particular, anionic surfactants and nonionic surfactants are preferred. Fluorine surfactants can be also involved in these surfactants. In the emulsion polymerization, further, the following suspension stabilizers or thickeners may be used together with the emulsifiers in order to control viscosity of the reaction system, granular diameter or the like.

The suspension stabilizers used in said suspension polymerization illustratively include water-soluble suspension stabilizers such as polyvinyl alcohol, sodium polyacrylate, methyl vinyl ether-maleic anhydride copolymer, water-soluble polyether, hydroxyethyl cellulose, carboxymethyl cellulose, starch, gelatin, alginic acid salt and the like.

In the copolymerization of the monomer mixture, all the amount of each reaction ingredient inclusive of each monomer, radical polymerization initiator and the like may be added, otherwise part or whole of these ingredients may be added in divisions after starting the reaction or continuously. Polymerization can be ordinarily effected in an atmosphere free of oxygen (nitrogen atmosphere) at temperature from 0 to 60°C, but the reaction conditions such as temperature, stirring speed or the like can be appropriately changed during the reaction. Polymerization may be effected either by continuous process or by batch process. Ordinary conversion of the polymerization is not less than 85%, preferably not less than 90%. If the conversion of the polymerization is below 85%, the composition is apt to lower the water developability.

The copolymer containing the carboxyl group can be subjected to at least partial hydrogenation of the repeating unit consisting of aliphatic conjugated diene. In this case, it is ordinarily hydrogenated prior to introduction of the photopolymerizable group described below.

Photopolymerizable groups introduced for preparing the photopolymerizable copolymer (1) include illustratively (meth)acryloyl group, alkenyl group, cinnamoyl group, cinnamylideneacetyl group, benzalacetophenone group, styrylpyridine group, α-phenylmaleinimide group, phenylazido group, sulfonylazido group, carbonylazido group, diazo group, o-quinonediazido group, furylacryloyl group, coumarin group, pyrone group, anthracene group, benzophenone group, benzoin group, stilben group, dithiocarbamate group, xanthate group, 1,2,3-thiadiazole group, cyclopropene group, azadioxabicyclo group and the like. (Meth)acryloyl group, alkenyl group and cinnamoyl group are preferable, and in particular (meth)acryloyl group is preferred.

One or more sorts of these photopolymerizable groups can be introduced.

The photopolymerizable group can be introduced by reacting the carboxyl group-containing copolymer with a compound having both a group reactive to the following functional groups and a photopolymerizable group (hereinafter referred to as "photopolymerizable group-containing compound"). The reaction is conducted through the carboxyl group in the carboxyl group-containing copolymer as well as functional groups such as hydroxy group, amino group, epoxy group, carbonyl group or the like coming from the monomers (i) - (iv). Further, the carboxyl group-containing copolymer, having various functional groups used for the production of the photopolymerizable copolymer (1) can be directly prepared by copolymerizing a mixture of monomers or also by chemical treatment of a previously prepared copolymer.

The photopolymerizable group-containing compounds illustratively include α,β-ethylenic unsaturated carboxylic acids such as (meth)acrylic acid or the like; α,β-ethylenic carboxylic halide such as (meth)acrylic halide; epoxy group-containing esters of α,β-ethylenic unsaturated carboxylic acids such as glycidyl (meth)acrylate or the like; hydroxy group-containing esters of α,β-ethylenic unsaturated carboxylic acids such as hydroxyethyl (meth)acrylate, hydroxypropyl (meth)acrylate or the like; isocyanate group-containing esters of α,β-ethylenic unsaturated carboxylic acids obtained by reacting the hydroxy group-containing ester of α,β-ethylenic unsaturated carboxylic acids with equimolar amount of diisocyanate compound such as tolylene diisocyanate, methylene diisocyanate or the like.

For introducing the photopolymerizable group such as (meth)acryloyl group into the carboxyl group-containing copolymer, there can be adopted illustratively a) esterification of (meth)acrylic acid with epoxy group of a carboxyl group-containing copolymer, b) production of an acid anhydride by reacting (meth)acryloyl chloride with carboxyl group of a carboxyl group-containing copolymer, c) amidation by reacting (meth)acroyl chloride with amino group of a carboxyl group-containing copolymer, d) esterification by reacting glycidyl (meth)acrylate with carboxyl group of a carboxyl group-containing copolymer, e) urethane formation by reacting (meth)acrylic acid ester containing isocyanate group with hydroxy group of a carboxyl group-containing copolymer, f) urea formation by reacting (meth)acrylic acid ester containing isocyanate group with amino group of a carboxyl group-containing copolymer, g) amidation by reacting (meth)acrylic acid ester containing isocyanate group with carboxyl group or acid anhydride group of a carboxyl group-containing copolymer, and the like.

For introducing alkenyl group into the carboxyl group-containing copolymer, there can be illustratively adopted Wittig reaction of a carboxyl group-containing copolymer containing carbonyl group (aldehyde group, ketone group) with an alkylidenephosphorane compound; reaction of a carboxyl group-containing copolymer containing p-hydroxystyrene with allyl bromide; and the like. For introducing cinnamoyl group there can be basically adopted those methods similar to those for introducing the (meth)acryloyl group.

In the present invention, the reaction of a photopolymerizable group-containing compound and a carboxyl group-containing copolymer for introducing a photopolymerizable group into said carboxyl group-containing copolymer can be selectively effected between specific functional groups, and two or more sorts of reactions can be made simultaneously.

Reaction ratio in introducing a photopolymerizable group into the carboxyl group-containing copolymer varies depending upon content of the functional group in the carboxyl group-containing copolymer, selection of the photopolymerizable group-containing compound and desired properties of the photosensitive resin composition. An appropriate amount of the photopolymerizable group-containing compound is 0.1 to 20 parts by weight, preferably 0.1 - 15 parts by weight based on 100 parts by weight of the carboxyl group-containing copolymer. If it is below 0.1 part by weight, photosetting of the photosensitive resin composition becomes insufficient and provides low strength after photosetting. If it exceeds 20 parts by weight, water-developability of the composition would be insufficient.

When the carboxyl group-containing copolymer is granular, the reaction of the copolymer with a photopolymerizable group-containing compound can be effected in heterogeneous phase while the copolymer is kept to be granular or in homogeneous phase of the copolymer in appropriate solvent.

Excellent balance of the water-developability of the photosensitive resin composition and the strength after photosetting can be achieved in the present invention by using the photopolymerizable copolymer (1) produced by introducing the photopolymerizable group into the carboxyl group-containing copolymer.

### Second Ingredient:

The photopolymerizable unsaturated monomer (2), second ingredient of the photosensitive resin composition of the present invention, is a compound having unsaturated group which can be polymerized under photoirradiation in the presence of the photopolymerization initiator (4) described below.

Examples of the photopolymerizable unsaturated monomer (2) are vinylaromatic compounds such as styrene, α-methylstyrene, o-methylstyrene, m-methylstyrene, p-methylstyrene, p-t-butylstyrene, divinylbenzene, diisopropenylbenzene, o-chlorostyrene, m-chlorostyrene, p-chlorostyrene, 1,1-diphenylethylene, p-methoxystyrene, N,N-dimethyl-p-aminostyrene, N,N-diethyl-p-aminostyrene, vinylpyridine or the like; unsaturated nitriles such as (meth)acrylonitrila, α-chloroacrylonitrile, α-chloromethylacrylonitrile, α-methoxyacrylonitrile, α-ethoxyacrylonitrile, crotononitrile, cinnamonitrile, itaconic dinitrile, maleic dinitrile, fumaric dinitrile or the like; alkyl (meth)acrylates such as methyl (meth)acrylate, ethyl (meth)acrylate, n-propyl (meth)acrylate, isopropyl (meth)acrylate, n-butyl (meth)acrylate, isobutyl (meth)acrylate, sec-butyl (meth)acrylate, t-butyl (meth)acrylate, n-amyl (meth)acrylate, n-octyl (meth)acrylate, 2-ethylhexy (meth)acrylate, lauryl (meth)acrylate, stearyl (meth)acrylate or the like; unsaturated carboxylic acid esters such as methyl crotonate, ethyl crotonate, propyl crotonate, butyl crotonate, methyl cinnamate, ethyl cinnamate, propyl cinnamate, butyl cinnamate, dimethyl itaconate, diethyl itaconate, dimethyl maleate, diethyl maleate, dimethyl fumarate, diethyl fumarate or the like; fluoroalkyl (meth)acrylates such as trifluoroethyl (meth)acrylate, pentafluoropropyl (meth)acrylate, heptafluoroacrylate or the like; hydroxyalkyl (meth)acrylates such as 2-hydroxyethyl (math)acrylate, 2-hydroxypropyl (meth)acrylate, 3-hydroxypropyl (meth)acrylata or the like; mono(moth)acrylates of polyalkylene glycols such as polyethylene glycol mono(meth)acrylate, polypropylene glycol mono(meth)acrylate or the like; alkoxyalkyl (meth)acrylates such as 2-methoxyethyl (meth)acrylate, 2-ethoxyethyl (meth)acrylate, 2-methoxypropyl (meth)acrylate, 2-ethoxypropyl (meth)acrylate, 3-methoxypropyl (meth)acrylate, 3-ethoxypropyl (meth)acrylate or the like; cyanoalkyl (meth)acrylates such as cyanoethyl (meth)acrylate, cyanopropyl (meth)acrylate or the like; aryloxyalkyl (meth)acrylates such as 2-phenoxyethyl (meth)acrylate, 2-phenoxypropyl (meth)acrylate, 3-phenoxypropyl (meth)acrylate or the like; mono(meth)acrylates of alkoxypolyalkylene glycols such as methoxypolyethylene glycol mono(meth)acrylate, ethoxypolyethylene glycol mono(meth)acrylate, methoxypolypropylene glycol mono(meth)acrylate or the like; mono(meth)acrylates of aryloxylpolyalkylene glycols such as phenoxypolyethylene glycol mon(meth)acrylate, phenoxypolypropylene glycol mono(meth)acrylate or the like; di(meth)acrylates of alkylene glycols such as ethylene glycol di(meth)acrylate, propylene glycol di(meth)axrylate, 1,4-butanediol di(meth)acrylate, 1,5-pentanediol di(meth)acrylate, 1,6-hexanediol di(meth)acrylate or the like; di(meth)acrylates of polyalkylene glycol (unit number of alkylene glycol: e.g. 2-23; e.g. polyethylene glycol, polypropylene glycol or the like); di(meth)acrylates of a polymer having hydroxy groups at both ends (e.g. both terminal hydroxypolybutadiene, both terminal hydroxypolyisoprene, both terminal hydroxybutadiene-acrylonitrile copolymer, both terminal hydroxypolycaprolactone or the like); oligo(meth)acrylates of di(meth)acrylate, tri(meth)acrylate, tetra(meth)acrylate or the like of polyhydric alcohols in trivalence or more (e.g. glycerin, 1,2,4-butanetriol, trimethylolalkane (carbon number of alkane = 1-3), tetramethylolalkane (carbon number of alkane = 1-3; pentaerythritol or the like); oligo(meth)acrylates such as tri(meth)acrylate, tetra(meth)acrylate or the like of polyalkylene glycol adducts of polyhydric alcohols in trivalence or more; oligo(meth)acrylates of cyclic polyhydric alcohols (e.g. 1,4-cyclohexanediol, 1,2-benzenediol, 1,4-dihydroxyethylbenzene or the like); oligo(meth)acrylate prepolymers of polyester (meth)acrylate, epoxy (meth)acrylate, urethane (meth)acrylate, alkyd resin (meth)acrylate, silicon resin (meth)acrylate, spiran resin (meth)acrylate or the like; unsaturated carboxylic acids such as (meth)acrylic acid, crotonic acid, cinnamic acid, itaconic acid, itaconic anhydride, maleic acid, maleic anhydride, fumaric acid, citraconic acid, mesaconic acid or the like; free carboxyl group-containing esters such as monomethyl ester, monoethyl ester, monopropyl ester, monobutyl ester, monohexyl ester, monocytyl ester or the like of unsaturated polyhydric carboxylic acids (e.g. itaconic acid, maleic acid, fumaric acid, citraconic acid, mesaconic acid or the like); polyvalent esters such as dimethyl ester, diethyl ester, dipropyl ester, dibutyl ester, dihexyl ester, dioctyl ester or the like of unsaturated polyhydric carboxylic acids (e.g. itaconic acid, maleic acid, fumaric acid, citraconic acid, mesaconic acid or the like); unsaturated amides such as (meth)acrylamide, N-hydroxymethyl·(meth)acrylamide, N-(2-hydroxyethyl)(meth)acrylamide, N,N-bis(2-hydroxyethyl)(meth )acrylamide, N,N'-methylenebis(meth)acrylamide, N,N'-ethylenebis(meth)acrylamide, N,N'-hexamethylenebis(meth)acrylamide, crotonamide, cinnamamide or the like; halogenated vinyl compounds such as vinyl chloride, vinylidene chloride or the like; unsaturated alcohol esters such as vinyl acetate, allyl acetate, divinyl phthalate, diallyl phthalate or the like; and cycloolefins such as cyclopentene, dicyclopentadiene, ethylidenenorbornene, norbornadiene or the like. Preferred are nonaethylene glycol mono(meth)acrylate, lauryl (meth)acrylate, hexanediol (meth)acrylate, trimethylolpropane tri(meth)acrylate, and (meth)acrylic acid.

These photopolymerizable unsaturated monomers (2) can be used solely or in a mixture of two or more members. In the present invention, the photosensitive resin composition after photosetting gives desirable properties by selecting appropriately these monomers or combination thereof.

Fluidity of the photosensitive resin composition of the present invention can be freely taken from waxy or rubber form to low viscous liquid form according to the prescribed amount of the photopolymerizable unsaturated monomer (2). Thus, an amount of the photopolymerizable unsaturated monomer (2) can be appropriately selected according to the object of the photosensitive resin composition, but an amount of the monomer (2) is 10 - 100,000 parts by weight, preferably 50 - 10,000 parts by weight based on 100 parts by weight of the photopolymerizable copolymer (1). If the amount of the photopolymerizable unsaturated monomer (2) is below 10 parts by weight, there is an inclination to lower the strength of the photosensitive resin composition after photosetting, and if it exceeds 100,000 parts by weight, the composition after photosetting shows too big contraction and the composition has poor balance of water developability and water resistance upon cured. Further, freedom in planning the viscosity of the composition is apt to become small.

### Third Ingredient:

Then, the amino group-containing compound (3), third ingredient in the photosensitive resin composition of the present invention, includes ammonia and organic compounds having one or more primary to tertiary amino groups.

Examples of the organic compounds having one or more primary to tertiary amino groups are primary amines such as methylamine, ethylamine, propylamine, butylamine or the like; secondary amines such as dimethylamine, methylethylamine, diethylamine, methylpropylamine, ethylpropylamine, dipropylamine, methylbutylamine, ethylbutylamine, propylbutylamine, dibutylamine or the like; tertiary amines, e.g. trialkylamines such as trimethylamine, methyldiethylamine, dimethylethylamine, triethylamine, dimethylpropylamine, methylethylpropylamine, diethylpropylamine, methyldipropylamine, ethyldipropylamine; tripropylamine, dimethylbutylamine, methyldibutylamine, methylethylbutylamine, diethylbutylamine, ethyldibutylamine, methylpropylbutylamine, ethylpropylbutylamine, dipropylbutylamine, propyldibutylamine, tributylamine or the like; alkylalkanol amines such as dimethylethanolamine, methyldiethanolamine, diethylethanolamine, ethyldiethanolamine or the like; trialkanolamines such as triethanolamine, diethanolpropanolamine, ethanoldipropanolamine, tripropanolamine or the like; N,N-dialkylaminoalkoxyalkanols such as N,N-dimethylaminoethoxyethanol, N,N-diethylaminoethoxyethanol, N,N-dimethylaminoethoxypropanol, N,N-diethylaminoethoxypropanol or the like; N,N-dialkylaminoalkyl (meth)acrylates such as N,N-dimethylaminoethyl (meth)acrylate, N,N-diethylaminoethyl (meth)acrylate, N,N-dipropylaminoethyl (meth)acrylate, N,N-dimethylaminopropyl (meth)acrylate, N,N-diethylaminopropyl (meth)acrylate, N,N-dipropylaminopropyl (meth)acrylate or the like; N,N-dialkylaminoalkoxyalkyl (meth)acrylates such as N,N-dimethylaminoethoxyethyl (meth)acrylate, N,N-diethylaminoethoxyethyl (meth)acrylate or the like; tertiary amino group-containing (meth)acrylamides such as N-(N',N'-dimethylaminoethyl)(meth)acrylamide, N-(N',N'-diethylaminoethyl)(meth)acrylamide, N-(N',N'-dimethylaminopropyl)(meth)acrylamide, N-(N',N'-diethylaminopropyl)(meth)acrylamide or the like; tertiary amino group-containing carbamates such as N,N-dimethylaminoethyl-N'-(meth)acryloyl carbamate, N,N-diethylaminoethyl-N'-(meth)acryloyl carbamate or the like. Preferred are N-(3-dimethylaminopropyl) (meth)acrylamide, N-(2-dimethylaminopropyl) (meth)acrylamide, N-(2-dimethylaminoethyl) (meth)acrylamide, 2-diethylaminoethyl (meth)acrylate, 2-diethylaminopropyl (meth)acrylate, 2-dimethylaminopropyl (meth)acrylate, triethanolamine, and tributylamine.

These (3) amino group-containing compounds can be used solely or in a mixture of two or more members.

Of the amino group-containing compounds (3), tertiary amines giving favorable water-developability are preferred. In particular, α,β-ethylenic unsaturated compounds such as tertiary amino group-containing (meth)acrylates, tertiary amino group-containing (meth)acrylamide or the like are preferred in view of the strength of the photosensitive resin composition after photosetting.

An amount of the amino group-containing compound (3) can be appropriately selected according to the object for using the photosensitive resin composition, but appropriate content of amino group is not less than 0.5 mols, preferably not less than 0.8 mols per 1 mol of carboxyl group in the photopolymerizable copolymer (1). If the amino group content in the amino group-containing compound (3) is below 0.5 mols, the water-developability would be insufficient. However, even if the amino group content exceeds 2 mols, the water-developability would not improve.

In the present invention there is a possibility that the photopolymerizable unsaturated monomer (2) is same as the amino group-containing compound, but at that time, an amount of the compounds to the photopolymerizable copolymer is to be adjusted so as to suffice the appropriate range of both compounds, respectively.

### Fourth Ingredient:

Further, the photopolymerization initiator (4), fourth ingredient in the photosensitive resin composition of the present invention, can initiate or sensitize the polymerization of the photopolymerizable copolymer (1) with the photopolymerizable unsaturated monomer (2) under photoirradiation as well as also, as preferable embodiments of the present invention, the polymerization of a compound having α,β-ethylenic unsaturated group in the amino group-containing compounds (3).

Examples of the photopolymerization initiator (4) are α-diketones such as diacetyl, methylbenzoyl formate, benzil or the like; acyloins such as benzoin, pivaloin or the like; acyloin ethers such as benzoin methyl ether, benzoin ethyl ether, benzoin isopropyl ether, benzoin isobutyl ether or the like; polynucleic quinones such as anthraquinone, 2-ethylanthraquinone, 2-t-butylanthraquinone, 1,4-naphthoquinone or the like; acetophenone such as acetophenone, 2-hydroxy-2-methylpropiophenone, 1-hydroxycyclohexyl phenyl ketone, 2,2-dimethoxyphenyl acetophenone, 2,2-diethoxyacetophenone, trichloroacetophenone or the like; benzophenones such as benzophenone, methyl-o-benzoylbenzoate, Michler's ketone or the like; xanthones such as xanthone, thioxanthone, 2-chlorothioxanthone or the like.

An amount of the photopolymerization initiator (4) is 0.1 - 20 parts by weight, preferably 1 - 10 parts by weight based on 100 parts by weight of the photopolymerizable copolymer (1). If the amount of the photopolymerization initiator (4) is below 0.1 part by weight, there is a possibility that the photosensitive resin composition would give insufficient photosetting. Further, even if it exceeded 20 parts by weight, it is not economical because all of the photopolymerization initiator (4) does not pertain in the photosetting. Furthermore, it is unfavorable because sometimes the initiator induces ill compatibility with the photopolymerizable unsaturated monomer (2) and the amino group-containing compound (3) and poor dispersibility.

The photosensitive resin composition of the present invention can be mixed with various additives according to the necessity.

As said additives there can be illustrated thermal polymerization inhibitors which work as a preservation stabilizer.

Examples of the thermal polymerization inhibitor are hydroxyaromatic compounds such as hydroquinone, hydroquinone monomethyl ether, mono-t-butylhydroquinone, catechol, p-t-butylcatechol, p-methoxyphenol, p-t-butylcatechol, 2,6-di-t-butyl-p-cresol, 2,6-di-t-butyl-m-cresol, pyrogallol, β-naphthol or the like; aromatic quinones such as benzoquinone, 2,5-diphenyl-p-benzoquinone, p-toluquinone, p-xyloquinone or the like; nitro compounds or nitron compounds such as nitrobenzene, m-dinitrobenzene, 2-methyl-2-nitrosopropane, α-phenyl-t-butylnitron, 5,5-dimethyl-1-pyroline-1-oxide or the like; amines such as chloranil-amines, diphenylamine, diphenylpicrylhydrazine, phenol-α-naphthylamine, pyridine, phenothiazine or the like; sulfides such as dithiobenzoylsulfide, dibenzyltetrasulfide or the like; unsaturated compounds such as 1,1-dipheylethylene, α-methylthioacrylonitrile or the like; thiazine dyestuffs such as thionine blue, toluidine blue, methylene blue or the like; stable radicals such as 1,1-diphenyl-2-picrylhydrazil, 1,3,5-triphenylpheldazil, 4-hydroxy-2,2,6,-tetramethylpiperidine-1-oxyl, 2,6-di-t-butyl-α-(3,5-di-t-butyl)-4-oxo-2,5-cyclohexadine-1-ylidene-p-trioxyl or the like.

An amount of the thermal polymerization inhibitor is about 0.001 - 2.0 parts by weight based on 100 parts by weight of the whole photosensitive resin composition .

Further, other additives such as antioxidants, fillers, reinforcing agents, plasticisers, halation inhibitors, adhesion aids or the like can be added.

The photosensitive resin composition of the present invention can be ordinarily prepared by mixing sufficiently photopolymerizable copolymer (1), photopolymerizable unsaturated monomer (2), amino group-containing compound (3) and photopolymerization initiator (4), if necessary, together with various additives with heating in a kneader, intermixer or the like. The resulting composition can be freely regulated from waxy or rubber form with no fluidity to low viscous liquid form having good fluidity, and degree of the fluidity can be appropriately selected according to the object for using the composition. An appropriate amount of solvents can be added to the composition, if low viscous compositions is desirable in particular.

For preparing photosensitive resin plates from the photosensitive resin composition of the present invention, various methods can be adopted, depending upon the degree of fluidity of the composition.

In case of compositions having no fluidity or low fluidity, for example, the composition is passed through a spacer having appropriate gap, coated on appropriate support with roll coater or the like coating installation, or subjecting to compressing molding, extrusion molding, calendar molding or the like to give a desirable film thickness of stereotype plate.

Further, other stereotype plate can be made by coating a composition of having good fluidity on a support by appropriate coating methods such as roll coat, calendar coat, doctor blade coat, air knife coat or the like, but in particular, such a composition having good fluidity is useful as a resist suitable for spin coat.

Thus prepared photosensitive resin plate or resist can form a clear relief image by exposing to chemically activated light such as ultraviolet light or the like through negative film of desirable patterns, washing and removing the unexposed part with water and drying. In this case, if necessary, it can be exposed to light again.

### EXAMPLES

Concrete explanation of the present invention will be given further by illustrating Examples and Comparative Examples, but the present invention is not limited to those examples unless it exceeds the gist.

### Example 1.

### (1) Photopolymerizable copolymer containing photopolymerizable groups

Monomer mixture consisting of butadiene/methacrylic acid/ divinylbenzene/methyl methacrylate = 80/6.5/1.0/12.5 (mol %) was mixed with sodium laurylsulfate as an emulsifier and potassium persulfate as a polymerization initiator in an autoclave of 20 L, and the resulting mixture was subjected to emulsion polymerization. After the conversion for polymerization of all monomers got to 90%, the polymerization was allowed to stop by adding 0.2 parts by weight of hydroxylamine sulfate per 100 parts by weight of monomer. Then,the reaction mixture was warmed and subjected to steam distillation in vacuo to remove the remaining monomers. The granular diameter of the resulting copolymer latex was measured in a conventional manner, and 71 nm was found as an average granular diameter. Further, the resulting copolymer latex was salted out with calcium chloride, washed with water and dried to give carboxy group-containing copolymer in crumb form.

Then, 100 parts by weight of this carboxy group-containing copolymer was mixed with 2 parts by weight of glycidyl methacrylate and a catalytic amount of tetra-n-butylammonium bromide, and the resultant mixture was allowed to react at 70°C for 10 hours. The reaction mixture was salted out and aggregated with calcium chloride, washed with water and dried to give granular photopolymerizable copolymer (1) containing methacryloyl group via ester bonding.

### Photosensitive resin composition

To 100 parts by weight in the photopolymerizable copolymer (1) thus obtained were added 10 parts by weight of nonaethylene glycol methacrylate and 10 parts by weight of trimethylolpropane trimethacrylate as photopolymerizable unsaturated monomer (2), 10 parts by weight of N,N-dimethylaminopropylacrylamide as amino group-containing compound (3), 3 parts by weight of 2,2-dimethoxyphenyl acetophenone as photopolymerization initiator (4) and 0.5 parts by weight of p-t-butylcatechol as a preservation stabilizer, and the resultant mixture was stirred in a kneader regulated at 50°C for 30 minutes to give a photosensitive resin composition. The resulting composition was transparent and waxy.

### Evaluation

Photosensitive resin plate in 0.5 mm thickness was made by coating the photosensitive resin composition obtained above on a polyester sheet.

Water-developability of the photosensitive resin composition was evaluated by brushing the resin layer of the resin plate with Developer (JOW-A-4P) made by Nippon Denshi Seiki Company in warm water at 45°C to measure the time required for dissolving out completely the resin layer (hereinafter referred to as "time needed for dissolving out").

Further, the resin plate was exposed to light with Exposing machine (JE-A-SS) made by Nippon Denshi Seiki Company for 6 minutes, and tensile strength, elongation at rupture and impact resilience were measured according to JIS K 6301.

As the result, the composition was found to have excellent balance of properties with excellent tensile strength and better elongation at rupture and impact resilience.

Table 1 shows the result above.

### Example 2.

Monomer mixture consisting of butadiene/methacrylic acid/ divinylbenzene/2-hydroxyethyl methacrylate/methyl methacrylate = 78.0/6.7/1.0/1.0/12.7 (mol %) was subjected to emulsion polymerization in the same manner as in Example 1 to give copolymer latex having 73 nm of average granular diameter. The resultant copolymer latex was salted out, washed with water and dried in the same manner as in Example 1 to give a carboxy group-containing copolymer in crumb form.

On the other hand, isocyanate group-containing methacrylic acid ester (2-HEM/TDI adduct) was prepared by reacting 2-hydroxyethyl methacrylate (2-HEM) with equimolar amount of tolylene diisocyanate (TDI).

To 100 parts by weight of the carboxy group-containing copolymer were added 4.4 parts by weight of the isocyanate group-containing methacrylic acid ester (2-HEM/TDI adduct) and catalytic amount of di-n-butyltin dilaurate, and the resultant mixture was allowed to react in a kneader warmed at 50°C for 10 minutes to give granular photopolymerizable copolymer (1) containing methacryloyl group via urethane bonding.

Then, a photosensitive resin composition was prepared by prescribing the composition as shown in Table 1 and evaluated in the same manner as in Example 1.

As the result, the composition was found to have excellent balance of properties with favorable water-developing property, excellent tensile strength, better elongation at rupture and impact resilience.

Table 1 shows the result above.

### Example 3.

Monomer mixture consisting of butadiene/methacrylic acid/ ethylene glycol dimethacrylate/ethyl acrylate = 80/6.5/1.0/ 12.5 (mol%) was subjected to emulsion polymerization in the same manner as in Example 1 to give a copolymer latex of 65 nm in average granular diameter. Production of the photopolymerizable copolymer (1) and preparation and evaluation of the resulting photosensitive resin composition were effected in the same manner as in Example 1 except for using said copolymer latex.

As the result, the composition was found to have excellent balance of properties with favorable water-developing property, excellent tensile strength, better elongation at rupture and impact resilience.

Table 1 shows the result above.

### Example 4.

Monomer mixture consisting of butadiene/divinylbenzene/2-hydroxyethyl methacrylate/ethyl acrylate = 78.6/6.7/1.0/1.0/ 12.7 (mol%) was subjected to emulsion polymerization in the same manner as in Example 1 to give a copolymer latex of 80 nm in average granular diameter. The copolymer latex was salted out, washed with water and dried in the same manner as in Example 1 to give a carboxy group-containing copolymer in crumb form.

On the other hand, isocyanate group-containing methacrylic acid ester (2-HEM/TDI adduct) was prepared in the same manner as in Example 2.

The carboxy group-containing copolymer was dissolved in chloroform to give a homogeneous solution, which was mixed with 4.4 parts by weight of the isocyanate group-containing methacrylic acid ester (2-HEM/TDI adduct) to 100 parts by weight of said carboxy group-containing copolymer and a catalytic amount of di-n-butyltin dilaurate. The resultant mixture was allowed to react under reflux to give (1) photopolymerizable copolymer containing methacryloyl group introduced via urethane bonding.

Then, the photosensitive resin composition was prepared by prescribing the composition as shown in Table 1 and evaluated in the same manner as in Example 1.

At the result the composition was found to have excellent balance of properties with favorable water-developing property, excellent tensile strength, better elongation at rupture and impact resilience.

Table 1 shows the result above.

### Example 5.

A carboxy group-containing copolymer in crumb form was made from a copolymer prepared from a monomer mixture consisting of butadiene/methacrylic acid/divinylbenzene/Z-hydroxyethyl methacrylate/methyl methacrylate = 78.6/6.7/1.0/ 1.0/12.7 (mol %).

On the other hand, cinnamyl alcohol (CA) was allowed to react with equimolar amount of tolylene diisocyanate (TDI) while paying attention to avoid exposure to light during the synthetic operation, whereby isocyanate group-containing cinnamic acid ester (CA/TDI adduct) was obtained.

To 100 parts by weight of said carboxy group-containing copolymer were added 4.4 parts by weight of said isocyanate group-containing cinnamic acid ester (CA/TDI adduct) and a catalytic amount of di-n-butyltin dilaurate, and the resultant mixture was allowed to react in a kneader warmed at 50°C for 10 minutes to give granular (1) photopolymerizable copolymer containing cinnamoyl group introduced via urethane bonding.

Then, the photosensitive resin composition was prepared by prescribing the composition as shown in Table 1 and evaluated in the same manner as in Example 1.

As the result, the composition was found to have excellent balance of properties with favorable water-developing property, excellent tensile strength, better elongation at rupture and impact resilience.

Table 1 shows the result above.

### Comparative Example 1.

Preparation and evaluation of the photosensitive resin composition were effected in the same manner as in Example 1 except that no photopolymerizable group was introduced into the carboxy group-containing copolymer.

As the result, the composition was found to have favorable water developing property with markedly lowered tensile strength and low elongation at rupture.

Table 1 shows the result above.

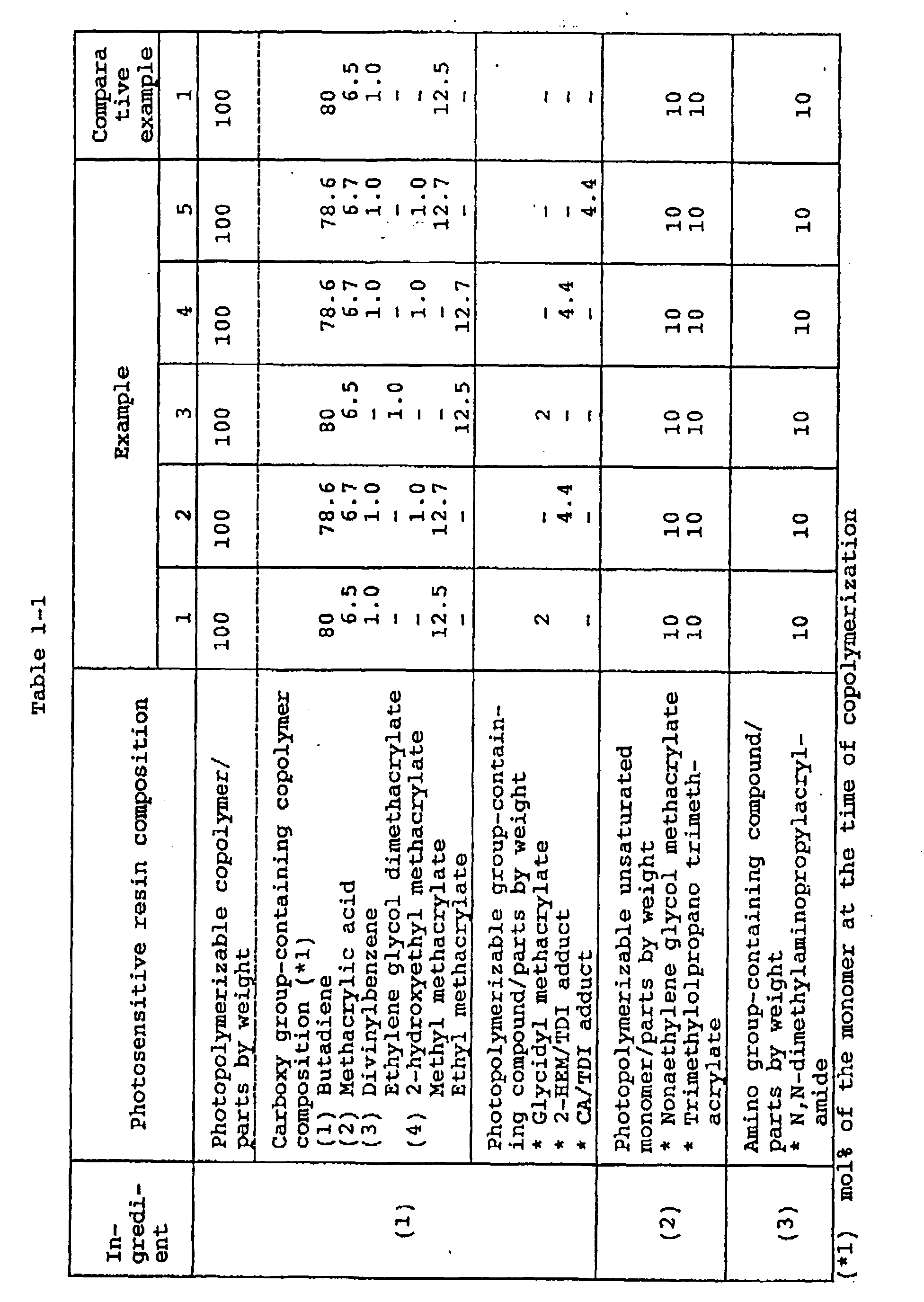

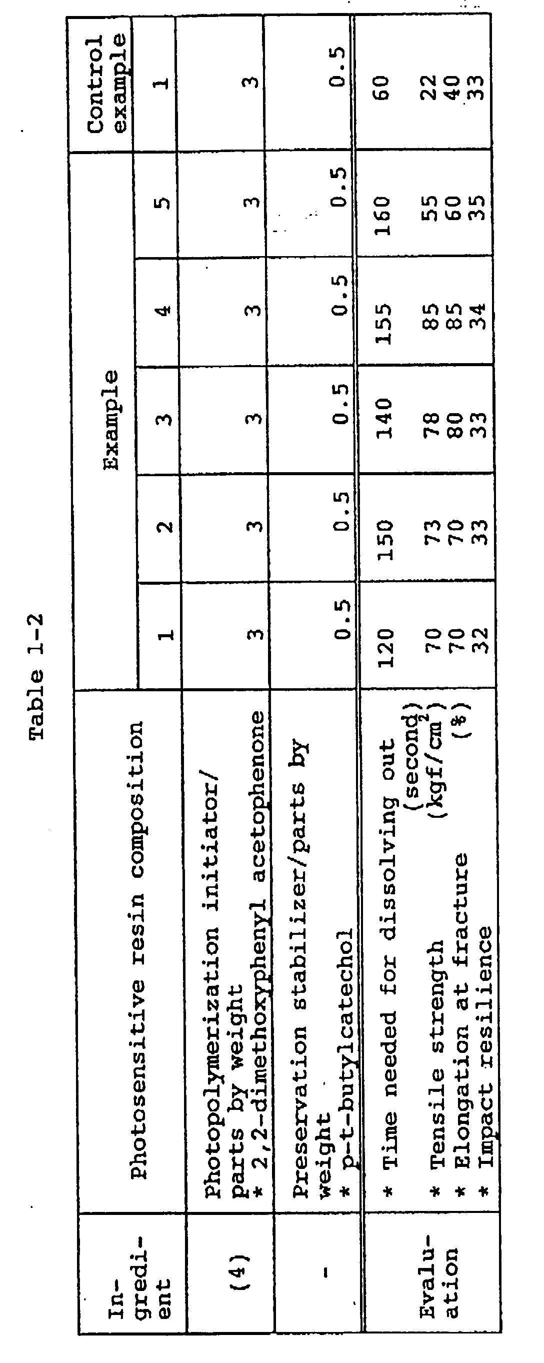

The photosensitive resin composition is suitable for water developing and, upon photosetting, has excellent strength of resin plate, excellent elongation at rupture and good impact resilience. The composition can freely control its viscosity from waxy or rubber like form with no fluidity to low viscous liquid form. The composition is suitable for photosensitive material which does not contain organic solvent, especially in the field of printing plate, photoresist or the like. It is also useful for printing ink, photosensitive paint, photosensitive adhesive, photomolding material or the like.

## Claims

1. A photosensitive resin composition comprising:
(1) a photopolymerizable copolymer prepared by introducing a photopolymerizable group into a copolymer made from a monomer mixture containing (i) 10 - 95 mol% of an aliphatic conjugated diene, (ii) 0.1 - 30 mol% of a carboxylic group-containing ethylenic unsaturated monomer, (iii) 0,1 - 20 mol% of a compound having at least two polymerizable unsaturated groups and (iv) 0 - 30 mol% of another copolymerizable monomer ((i)+(ii)+(iii)+(iv) = 100 mol%), through a reaction with a photopolymerizable group-containing compound via the functional group contained in the copolymer therein, wherein the photopolymerizable group-containing compound is included in an amount of 0.1 to 20 parts by weight, based on 100 parts by weight of the carboxyl group-containing copolymer,
(2) a photopolymerizable unsaturated monomer,
(3) an amino group-containing compound, and
(4) a photopolymerization initiator.

2. A photosensitive resin composition according to claim 1 wherein said aliphatic conjugated diene (i) is selected from the group consisting of butadiene, isoprene, 1,3-pentadiene, 1,3-hexadiene, 2,3-dimethylbutadiene, 4,5-diethyl-1,3-octadiene, 3-butyl-1,3-octadiene, chloroprene, 2,3-dichlorobutadiene and a mixture thereof.

3. A photosensitive resin composition according to claim 1 wherein said carboxyl-group containing ethylenic unsaturated monomer (ii) is selected from the group consisting of acrylic acid, methacrylic acid, crotonic acid, cinnamic acid, itaconic acid, maleic acid, and mono-ester of 2-hydroxyethyl (meth)acrylate and phthalic acid or succinic acid.

4. A photosensitive resin composition according to claim 1 wherein said compound (iii) having at least two polymerizable unsaturated groups is selected from the group consisting of ethylene glycol di(meth)acrylate, propylene glycol di(meth)acrylate, divinylbenzene, hexanediol di(meth)acrylate, pentaerythritol tri(meth)acrylate, pentaerythritol tetra(meth)acrylate, and trimethylolpropane tri(meth)acrylate.

5. A photosensitive resin composition according to claim 1 wherein other copolymerizable monomer (iv) is selected from the group consisting of styrene, acrylonitrile, methyl (meth)acrylate, ethyl (meth)acrylate, 2-ethylhexyl (meth)acrylate, methoxyethyl acrylate, methoxy diethylene glycol monoacrylate, methoxy dipropylene glycol monoacrylate, and lauryl (meth)acrylate.

6. A photosensitive resin composition according to claim 1 wherein said photopolymerizable copolymer (1) is in the form of granule.

7. A photosensitive resin composition according to claim 1 wherein said photopolymerizable unsaturated monomer (2) is selected from the group consisting of nonaethylene glycol mono(meth)acrylate, lauryl (meth)acrylate, hexanediol (meth)acrylate, trimethylolpropane tri(meth)acrylate, and (meth)acrylic acid.

8. A photosensitive resin composition according to claim 1 wherein said photopolymerizable unsaturated monomer (2) is present in the composition in an amount of 50 to 100,000 parts by weight based on 100 parts by weight of the photopolymerizable copolymer (1).

9. A photosensitive resin composition according to claim 1 wherein said amino group-containing compound (3) is selected from the group consisting of (meth)acrylates containing a tertiary amino group, (meth)acrylamides containing a tertiary amino group, trialkyl amines, alkyl alkanol tertiary amines, and trialkanol amines.

10. A photosensitive resin composition according to claim 9 wherein said amino group-containing compound (3) is selected from the group consisting of N-(3-dimethylaminopropyl) (meth)acrylamide, N-(2-dimethylaminopropyl) (meth)acrylamide, N-(2-dimethylaminoethyl) (meth)acrylamide, 2-diethylaminoethyl (meth)acrylate, 2-diethylaminopropyl (meth)acrylate, 2-dimethylaminopropyl (meth)acrylate, triethanolamine, and tributylamine.

11. A photosensitive resin composition according to claim 1 wherein a content of amino group of said amino group-containing compound (3) is not less than 0.5 mols per 1 mol of carboxyl group in the photopolymerizable copolymer (1).

12. A photosensitive resin composition according to claim 1 wherein said photopolymerization initiator (4) is selected from the group consisting of 2,2-dimethoxyphenylacetophenone, benzoin methyl ether, 2-chloroxanthone, 2-chlorothioxanthone, and 2-ethylanthraquinone.

13. A photosensitive resin composition according to claim 1 wherein said photopolymerization initiator (4) is present in the composition in an amount of 0.1 to 20 parts by weight based on 100 parts by weight of the photopolymerizable copolymer (1).

## Patentansprüche

1. Lichtempfindliche Harzzusammensetzung, enthaltend:
(i) ein photopolymerisierbares Copolymeres, das durch Einführen einer photopolymerisierbaren Gruppe durch Umsetzung einer eine photopolymerisierbare Gruppe enthaltenden Verbindung mit einem Copolymeren aus einem Monomerengemisch mit einem Gehalt an (i) 10-95 Mol-% eines aliphatischen, konjugierten Diens, (ii) 0,1-30 Mol-% eines eine Carboxylgruppe enthaltenden, ethylenisch ungesättigten Monomeren, (iii) 0,1-20 Mol-% einer Verbindung mit mindestens zwei polymerisierbaren, ungesättigten Gruppen und (iv) 0-30 Mol-% eines weiteren copolymerisierbaren Monomeren ((i)+(ii)+(iii)+(iv) = 100 Mol-%) über die funktionelle Gruppe erhalten worden ist,
wobei die die photopolymerisierbare Gruppe enthaltende Verbindung in einer Menge von 0,1 bis 20 Gewichtsteilen, bezogen auf 100 Gewichtsteile des Carboxylgruppen enthaltenden Copolymeren, enthalten ist,
(2) ein photopolymerisierbares, ungesättigtes Monomeres,
(3) eine Aminogruppen enthaltende Verbindung und
(4) einen Photopolymerisationsinitiator.

2. Lichtempfindliche Harzzusammensetzung nach Anspruch 1, wobei das aliphatische konjugierte Dien (1) aus der Gruppe Butadien, Isopren, 1,3-Pentadien, 1,3-Hexadien, 2,3-Dimethylbutadien, 4,5-Diethyl-1,3-octadien, 3-Butyl-1,3-octadien, Chloropren, 2,3-Dichlorbutadien und Gemische davon ausgewählt ist.

3. Lichtempfindliche Harzzusammensetzung nach Anspruch 1, wobei das Carboxylgruppen enthaltende, ethylenisch ungesättigte Monomere (ii) aus der Gruppe Acrylsäure, Methacrylsäure, Crotonsäure, Zimtsäure, Itaconsäure, Maleinsäure und Monoester von 2-Hydroxyethyl(meth)acrylat und Phthalsäure oder Bernsteinsäure ausgewählt ist.

4. Lichtempfindliche Harzzusammensetzung nach Anspruch 1, wobei die Verbindung (iii) mit mindestens zwei polymerisierbaren, ungesättigten Gruppen aus der Gruppe Ethylenglykoldi(meth)acrylat, Propylenglykoldi(meth)acrylat, Divinylbenzol, Hexandioldi(meth)acrylat, Pentaerythrittri(meth)acrylat, Pentaerythrittetra(meth)acrylat und Trimethylolpropantri(meth)acrylat ausgewählt ist.

5. Lichtempfindliche Harzzusammensetzung nach Anspruch 1, wobei das weitere copolymerisierbare Monomere (iv) aus der Gruppe Styrol, Acrylnitril, Methyl(meth)acrylat, Ethyl(meth)acrylat, 2-Ethylhexyl(meth)acrylat, Methoxyethylacrylat, Methoxydiethylenglykolmonoacrylat, Methoxydipropylenglykolmonoacrylat und Lauryl(meth)acrylat ausgewählt ist.

6. Lichtempfindliche Harzzusammensetzung nach Anspruch 1, wobei das photopolymerisierbare Copolymere (1), in Form eines Granulats vorliegt.

7. Lichtempfindliche Harzzusammensetzung nach Anspruch 1, wobei das photopolymerisierbare, ungesättigte Monomere (2) aus der Gruppe Nonaethylenglykolmono(meth)acrylat, Lauryl(meth)acrylat, Hexandiol(meth)acrylat, Trimethylolpropantri(meth)acrylat und (Meth)acrylsäure ausgewählt ist.

8. Lichtempfindliche Harzzusammensetzung nach Anspruch 1, wobei das photopolymerisierbare, ungesättigte Monomere (2) in der Zusammensetzung in einem Anteil von 50 bis 100 000 Gewichtsteilen, bezogen auf 100 Gewichtsteile des photopolymerisierbaren Copolymeren (1), vorhanden ist.

9. Lichtempfindliche Harzzusammensetzung nach Anspruch 1, wobei die Aminogruppen enthaltende Verbindung (3) aus der Gruppe (Meth)acrylate mit einem Gehalt an einer tertiären Aminogruppe, (Meth)acrylamide mit einem Gehalt an einer tertiären Aminogruppe, Trialkylamine, Alkylalkanol-tert.amine und Trialkanolamine ausgewählt ist.

10. Lichtempfindliche Harzzusammensetzung nach Anspruch 9, wobei die Aminogruppen enthaltende Verbindung (3) aus der Gruppe N-(3-Dimethylaminopropyl)-(meth)acrylamid, N-(2-Dimethylaminopropyl)-(meth)acrylamid, N-(2-Dimethylaminoethyl)-(meth)acrylamid, 2-Diethylaminoethyl(meth)acrylat, 2-Diethylaminopropyl(meth)acrylat, 2-Dimethylaminopropyl(meth)acrylat, Triethanolamin und Tributylamin ausgewählt ist.

11. Lichtempfindliche Harzzusammensetzung nach Anspruch 1, wobei der Anteil der Aminogruppen der Aminogruppen enthaltenden Verbindung (3) nicht weniger als 0,5 Mol pro 1 Mol Carboxylgruppen im photopolymerisierbaren Copolymeren (1) beträgt.

12. Lichtempfindliche Harzzusammensetzung nach Anspruch 1, wobei der Photopolymerisationsinitiator (4) aus der Gruppe 2,2-Dimethoxyphenylacetophenon, Benzoinmethylether, 2-Chlorxanthon, 2-Chlorthioxanthon und 2-Ethylanthrachinon ausgewählt ist.

13. Lichtempfindliche Harzzusammensetzung nach Anspruch 1, wobei der Photopolymerisationsinitiator (4) in der Zusammensetzung in einem Anteil von 0,1 bis 20 Gewichtsteilen, bezogen auf 100 Gewichtsteile des photopolymerisierbaren Copolymeren (1), vorhanden ist.

## Revendications

1. Composition de résine photosensible comprenant :
(1) un copolymère photopolymérisable préparé par introduction d'un groupe photopolymérisable dans un copolymère formé à partir d'un mélange de monomères contenant (i) 10-95 % en moles d'un diène conjugué aliphatique, (ii) 0,1-30 % en moles d'un monomère insaturé éthylénique carboxylé, (iii) 0,1-20 % en moles d'un composé ayant au moins deux groupes insaturés polymérisables et (iv) 0-30 % en moles d'un autre monomère copolymérisable ((i)+(ii)+(iii)+(iv))=100 % en moles), par une réaction avec un composé à groupe photopolymérisable par l'intermédiaire du groupe fonctionnel contenu dans le copolymère,
où le composé à groupe photopolymérisable est présent en une proportion de 0,1 à 20 parties en poids, par rapport à 100 parties en poids du copolymère carboxylé,
(2) un monomère insaturé photopolymérisable,
(3) un composé à groupe amino, et
(4) un amorceur de photopolymérisation.

2. Composition de résine photosensible selon la revendication 1, dans laquelle ledit diène conjugué aliphatique (i) est choisi dans le groupe constitué par le butadiène, l'isoprène, le 1,3-pentadiène, le 1,3-hexadiène, le 2,3-diméthylbutadiène, le 4,5-diéthyl-1,3-octadiène, le 3-butyl-1,3-octadiène, le chloroprène, le 2,3-dichlorobutadiène et un mélange de ceux-ci.

3. Composition de résine photosensible selon la revendication 1, dans laquelle ledit monomère insaturé éthylénique carboxylé (ii) est choisi dans le groupe constitué par l'acide acrylique, l'acide méthacrylique, l'acide crotonique, l'acide cinnamique, l'acide itaconique, l'acide maléique et le monoester du 2-hydroxyéthyl(méth)acrylate et de l'acide phtalique ou de l'acide succinique.

4. Composition de résine photosensible selon la revendication 1, dans laquelle ledit composé (iii) ayant au moins deux groupes insaturés polymérisables est choisi dans le groupe constitué par le di(méth)acrylate d'éthylèneglycol, le di(méth)acrylate de propylèneglycol, le divinylbenzène, le di(méth)acrylate d'hexanediol, le tri(méth)acrylate de pentaérythritol, le tétra(méth)acrylate de pentaérythritol et le tri(méth)acrylate de triméthylolpropane.

5. Composition de résine photosensible selon la revendication 1, dans laquelle l'autre monomère copolymérisable (iv) est choisi dans le groupe constitué par le styrène, l'acrylonitrile, le (méth)acrylate de méthyle, le (méth)acrylate d'éthyle, le (méth)acrylate de 2-éthylhexyle, l'acrylate de méthoxyéthyle, le monoacrylate de méthoxydiéthylèneglycol, le monoacrylate de méthoxydipropylèneglycol et le (méth)acrylate de lauryle.

6. Composition de résine photosensible selon la revendication 1, dans laquelle ledit copolymère photopolymérisable (1) est sous forme de granules.

7. Composition de résine photosensible selon la revendication 1, dans laquelle ledit monomère insaturé photopolymérisable (2) est choisi dans le groupe constitué par le mono(méth)acrylate de nonaéthylèneglycol, le (méth)acrylate de lauryle, le (méth)acrylate d'hexanediol, le tri(méth)acrylate de triméthylolpropane et l'acide (méth)acrylique.

8. Composition de résine photosensible selon la revendication 1, dans laquelle ledit monomère insaturé photopolymérisable (2) est présent dans la composition en une proportion de 50 à 100 000 parties en poids par rapport à 100 parties en poids du copolymère photopolymérisable (1).

9. Composition de résine photosensible selon la revendication 1, dans laquelle ledit composé (3) à groupe amino est choisi dans le groupe constitué par les (méth)acrylates contenant un groupe amino tertiaire, les (méth)acrylamides contenant un groupe amino tertiaire, les trialkylamines, les alkylalcanols amines tertiaires et les trialcanolamines.

10. Composition de résine photosensible selon la revendication 9, dans laquelle ledit composé (3) à groupe amino est choisi dans le groupe constitué par le (méth)acrylamide de N-(3-diméthylaminopropyle), le (méth)acrylamide de N-(2-diméthylaminopropyle), le (méth)acrylamide de N-(2-diméthylaminoéthyle), le (méth)acrylate de 2-diéthylaminoéthyle, le (méth)acrylate de 2-diéthylaminopropyle, le (méth)acrylate de 2-diméthylaminopropyle, la triéthanolamine et la tributylamine.

11. Composition de résine photosensible selon la revendication 1, dans laquelle la teneur en groupe amino dudit composé (3) à groupe amino n'est pas inférieure à 0,5 mole pour 1 mole de groupe carboxyle dans le copolymère photopolymérisable (1).

12. Composition de résine photosensible selon la revendication 1, dans laquelle ledit amorceur de photopolymérisation (4) est choisi dans le groupe constitué par la 2,2-diméthoxyphénylacétophénone, le benzoïne-méthyléther, la 2-chloroxanthone, la 2-chlorothioxanthone et la 2-éthylanthraquinone.

13. Composition de résine photosensible selon la revendication 1, dans laquelle ledit amorceur de photopolymérisation (4) est présent dans la composition en une proportion de 0,1 à 20 parties en poids par rapport à 100 parties en poids du copolymère photopolymérisable (1).
